# EUROPÄISCHE PATENTANMELDUNG

(11) **EP 1 187 209 A2**
(43) Veröffentlichungstag der Anmeldung: **13.03.2002**
(21) Anmeldenummer: 01119748.0
(22) Anmeldetag: 27.08.2001
(51) Int. Cl.: H01L 25/065, H01L 23/538

(54) **Elektronisches Bauteil mit gestapelten Bausteinen und Verfahren zu seiner Herstellung**

(30) Priorität: 06.09.2000 DE 10044148
(71) Anmelder: Infineon Technologies AG, 81669 München (DE)
(72) Erfinder: Wennemuth, Ingo, 81825 München (DE); Wörz, Andreas, 93309 Kelheim (DE)
(74) Vertreter: Schweiger, Martin, Dipl.-Ing.

(57) **Zusammenfassung**

Die vorliegende Erfindung betrifft ein elektronisches Bauteil mit gestapelten Bausteinen (1 - n) und ein Herstellungsverfahren desselben. Jeder Baustein (1 - n) weist einen Chip (C₁ bis Cₙ) auf. Jeder Chip (C₁ bis Cₙ) ist auf einer Stapelzwischenebene (Z₁ bis Zₙ) montiert. Die Stapelzwischenebenen (Z₁ bis Zₙ) eines Stapels weisen identische Layouts auf, während auf den Chips (C₁ bis Cₙ) irreversibel über Kontaktflächen (CS₁ bis CSₙ und CS₁₁ bis CSₙₙ) einstellbare Chipauswahlschaltungen (A₁ bis Aₙ) angeordnet sind, die eine irreversible Zuordnung der Kontaktflächen (CS₁ bis CSₙ) und (CS₁₁ bis CSₙₙ) zu den Stapelzwischenebenen (Z₁ bis Zₙ) ermöglichen.

## Beschreibung

Die Erfindung betrifft ein elektronisches Bauteil mit gestapelten Bausteinen und ein Verfahren zu seiner Herstellung, wobei jeder Baustein einen Chip aufweist, der auf einer Stapelzwischenebene, die von einem Systemträger gebildet wird, montiert ist.

Um einen Zugriff zu den einzelnen Chips zu gewährleisten, weist jede Stapelzwischenebene eine einstellbare Chipauswahlschaltung auf. Mit dieser Chipauswahlschaltung, die für jede Stapelzwischenebene ein unterschiedliches Layout erfordert, kann durch Adressierung auf jeden einzelnen Chip der gestapelten Bausteine des elektronischen Bauteils zugegriffen werden. Derartig gestapelte Bauteile haben den Nachteil, dass für jede Stapelzwischenebene ein eigenes Layout zu entwerfen und herzustellen ist. Damit ist nicht nur die Gefahr der Vertauschung der Stapelzwischenebenen beim Zusammenbau oder Stapeln der Bausteine zu einem elektronischen Bauteil entsprechend erhöht, sondern der erhebliche Aufwand für unterschiedlichen Konstruktionen der unterschiedlichen Leitungsstrukturen auf den Stapelzwischenebenen erfordert auch einen erhöhten Kostenaufwand bei der Herstellung eines elektronischen Bauteils mit gestapelten Bausteinen.

Aufgabe der Erfindung ist es, ein elektronisches Bauteil mit gestapelten Bausteinen anzugeben, bei dem der Aufwand des Entwurfs von Stapelzwischenebenen erheblich reduziert wird und die Adressierung der einzelnen Bausteine auf einfache Weise gewährleistet werden kann. Gelöst wird diese Aufgabe mit dem Gegenstand der unabhängigen Ansprüche. Vorteilhafte Weiterbildungen der Erfindung ergeben sich aus den Unteransprüchen.

Erfindungsgemäß wird die Aufgabe durch ein elektronisches Bauteil mit gestapelten Bausteinen gelöst, wobei jeder Baustein einen Chip aufweist, der auf einer Stapelzwischenebene montiert ist, und die Stapelzwischenebenen eines Stapels ein identisches Layout aufweisen, während auf den Chips irreversibel über Kontaktflächen einstellbare Chipauswahlschaltungen angeordnet sind, die eine irreversible Zuordnung der Kontaktflächen zu den Stapelzwischenebenen ermöglichen.

Diese Lösung hat den Vorteil, dass die Chipauswahlschaltung minimisiert werden kann und einen wesentlich geringeren Raumbedarf beansprucht als eine Chipauswahlschaltung, die auf einer Stapelzwischenebene angeordnet wird.

Ein weiterer Vorteil ist die identische Ausführung aller Stapelzwischenebenen, was einerseits für eine Massenproduktion förderlich ist und andererseits die Kosten für die Stapelzwischenebenen vermindert.

Die auf dem Chip angeordnete Chipauswahlschaltung der vorliegenden Erfindung weist in einer Ausführungsform eine Anzahl von Unterbrecherschaltungen auf. Die Anzahl der Unterbrecherschaltungen entspricht mindestens der Anzahl der Stapelzwischenebenen. Das hat den Vorteil, dass auf der Chipebene durch Auslösen der Unterbrecherschaltungen bereits die Chipadressierung irreversibel vorgenommen werden kann, so dass unterschiedliche Adressierschaltungen auf den Stapelzwischenebenen entfallen können. Darüber hinaus hat die Chipauswahlschaltung auf dem Chip den Vorteil, dass nicht von vornherein die Adressierung vorzunehmen ist, sondern an einer geeigneten Stelle im Herstellungsverfahren für das elektronische Bauteil die Chipadressierung bzw. die Chipauswahl vorgenommen werden kann. Die geeignete Stelle richtet sich dabei nach der Unterbrecherschaltungstechnologie und dem kostengünstigsten Zeitpunkt für eine irreversible Adressierung bzw. einer irreversiblen Zuordnung der Kontaktflächen zu den Stapelzwischenebenen der gestapelten Bausteine eines elektronischen Bauteils.

In einer bevorzugten Ausführungsform der Erfindung verfügt jede Unterbrecherschaltung über eine Eingangsleitung, die mit einer Eingangskontaktfläche verbunden ist, und über eine Ausgangsleitung, die mit einer Ausgangskontaktfläche verbunden ist. Über diese Eingangskontaktleitung bzw. die Ausgangskontaktleitung kann jede der Unterbrecherschaltungen individuell ausgelöst werden, so dass nur eine, die Stapelzwischenebene bestimmende Unterbrecherschaltung auf einem adressierten Chip in der Chipauswahlschaltung nicht ausgelöst wird.

In einer weiteren Ausführungsform der Erfindung weisen die Unterbrecherschaltungen eine gemeinsame Ausgangskontaktfläche und getrennte Eingangskontaktflächen auf. Mit einer derartigen Anordnung und Zusammenschaltung der Unterbrecherschaltungen wird der Flächenaufwand für die Chipauswahlschaltung auf dem Chip vermindert und gleichzeitig sichergestellt, dass jede einzelne Unterbrecherschaltung angesteuert werden kann.

Eine weitere Ausführungsform der Erfindung sieht vor, dass die Eingangskontaktflächen der Unterbrecherschaltungen über gebondete Drähte mit Eingangsanschlußflächen auf den Stapelzwischenebenen verbunden sind. Diese Ausführungsform hat den Vorteil, dass die Auslösung der Unterbrecherschaltungen nicht unmittelbar auf dem Chip über die Eingangskontaktflächen ausgelöst werden muss, sondern dass dazu Eingangsanschlußflächen auf den identischen Stapelzwischenebenen verwendet werden können, auf die der Zugriff durch die gegenüber den Eingangskontaktflächen größeren Eingangsanschlußflächen erleichtert ist.

In einer weiteren Ausführungsform der Erfindung sind die Eingangskontaktflächen auf den Stapelzwischenebenen mit Eingangskontaktstiften verbunden, welche die gestapelten Bausteine verbinden. Diese Eingangskontaktstifte werden folglich nach dem Übereinanderstapeln der Bausteine an den gestapelten Bausteine angebracht und reduzieren somit die Vielzahl der Kontaktflächen und Kontaktanschlussflächen auf eine minimale Anzahl von Eingangskontaktstiften, über die dann ein festgelegter Zugriff zu den einzelnen Bausteinen in dem Stapel möglich wird. Somit sind die Eingangskontaktstifte auch gleichzeitig die Adressierkontakte, über die ein Zugriff auf die unterschiedlichen Stapelzwischenebenen und Chips der gestapelten Bausteine von einer äußeren Schaltung beispielsweise auf einer Leiterplatte oder einem flexiblem Zuleitungsbus möglich wird.

In einer weiteren Ausführungsform der Erfindung ist die gemeinsame Ausgangskontaktfläche der Chipauswahlschaltung über jeweils einen gebondeten Draht mit einer gemeinsamen Ausgangsanschlußfläche auf der Stapelzwischenebene verbunden. Da bei dieser Ausführungsform der Erfindung alle Unterbrecherschaltungen eines Chips lediglich eine Ausgangskontaktfläche aufweisen, ist deshalb auf jeder Stapelzwischenebene auch nur noch eine Ausgangsanschlußfläche zur Verfügung zu stellen. Der Aufwand für die Stapelzwischenebenen reduziert sich von individuell angepaßten unterschiedlichen Adressierschaltungen auf jeder Stapelzwischenebene auf nun einheitliche Eingangsanschlußflächen und eine gemeinsamen Ausgangsanschlußfläche auf jeder Stapelzwischenebene.

In einer weiteren bevorzugten Ausführungsform der Erfindung sind die Eingangsanschlußflächen der Stapelzwischenebenen über Durchkontakte zu Eingangskontaktstiften auf der Grundfläche des elektronischen Bauteils mit gestapelten Bausteinen geführt. Diese Ausführungsform hat den Vorteil, dass die gesamte Grundfläche des elektronischen Bauteils mit Kontaktstiften versehen werden kann, so dass eine hohe Zahl von Adressierstiften sowie anderen Signal- und Leistungsanschlussstiften für ein elektronisches Bauteil mit gestapelten Bausteinen möglich werden.

In einer weitern Ausführungsform der Erfindung sind die Eingangsanschlußflächen der Stapelzwischenebenen im Randbereich jeder Stapelzwischenebene angeordnet und über Eingangskontaktstifte auf den Seiten des elektronischen Bauteils verbunden. Dazu wird der Randbereich eines Systemträgers, auf dem sich die Stapelzwischenebene befindet, an den Stellen metallisiert, die mit den Eingangskontaktstiften verbunden werden sollen.

Ein Verfahren zur Herstellung eines elektronischen Bauteils mit gestapelten Bausteinen unter irreversibler Festlegung und Zuordnung von Eingangskontaktstiften als Adressierkontakte weist folgende Verfahrensschritte auf:
- Aufbringen einer Chipauswahlschaltung mit einer Anzahl Unterbrecherschaltungen auf einem Chip, die getrennte Eingangskontaktflächen und eine gemeinsame Ausgangskontaktfläche aufweist,
- Aufbringen des Chips auf einem Systemträger mit einer Stapelzwischenebene, die eine Anzahl getrennter Eingangsanschlußflächen und eine gemeinsame Ausgangsanschlußfläche aufweist,
- Verbinden der Eingangskontaktflächen mit den Eingangsanschlußflächen und der Ausgangskontaktfläche mit der gemeinsamen Ausgangsanschlußfläche,
- Anlegen einer Unterbrecherschaltung zwischen der gemeinsamen Ausgangskontaktfläche über alle Unterbrecherschaltungen eines Chips auf einer Stapelzwischenebene und nacheinander aller Eingangskontaktflächen der Unterbrecherschaltungen dieser Stapelzwischenebene dieses Chips mit Ausnahme der Eingangskontaktfläche, die für diese Stapelzwischenebene kennzeichnend ist und einer Adressierung dienen soll,
- Stapeln einer Anzahl von Bausteinen aus Chips und Stapelzwischenebenen,
- Anbringen von Eingangskontaktstiften zur Verbindung der Eingangsanschlußflächen der gestapelten Bausteine.

Dieses Verfahren hat den Vorteil, dass auf einfache und wirtschaftliche Weise ein elektronisches Bauteil mit gestapelten Bausteinen hergestellt werden kann, wobei die Vielzahl der Unterbrecherschaltungen und die Vielzahl der unterschiedlichen Leitungen auf nur wenige Eingangskontaktstifte konzentriert werden kann, über welche die einzelnen Chips in den unterschiedlichen Stapelzwischenebenen adressierbar sind. Darüber hinaus hat das Verfahren den Vorteil, dass durch einfaches Auslösen der Unterbrecherschaltungen die Zuordnung der Chips zu den einzelnen Stapelzwischenebenen durchgeführt werden kann.

Bei einem weiteren Durchführungsbeispiel des Herstellungsverfahrens ist es vorgesehen, statt der Unterbrecherschaltungen Unterbrecherelemente auf den Chips anzuordnen, die mittels Laserverdampfen oder anderer Verdampfungsstrahltechnik unterbrochen werden können. Eine derartige Verfahrensvariation zur Herstellung eines elektronischen Bauteils mit gestapelten Bausteinen unter irreversibler Festlegung und Zuordnung von Eingangskontaktstiften als Adressenkontakte weist folgende Verfahrensschritte auf:
- Aufbringen einer Chipauswahlschaltung mit einer Anzahl von Unterbrecherelementen auf jedem Chip, die getrennte Eingangskontaktflächen und eine gemeinsame Ausgangskontaktfläche aufweisen,
- Auftrennen der Unterbrecherelemente vorzugsweise mittels Laserverdampfen, soweit sie nicht der Adressierung des Chips dienen,
- Aufbringen des Chips auf einem Systemträger mit einer Stapelzwischenebene, die eine Anzahl getrennter Eingangsanschlußflächen und eine gemeinsame Ausgangsanschlußfläche aufweist,
- Verbinden der Eingangskontaktflächen mit den Eingangsanschlußflächen und der Ausgangskontaktfläche mit der Ausgangsanschlußfläche,
- Stapeln einer Anzahl von Bausteinen aus Chips und Systemträgern mit Stapelzwischenebenen,
- Anbringen von Eingangskontaktstiften zur Verbindung der Eingangsanschlußflächen der gestapelten Bausteine.

Dieses Verfahren hat den Vorteil, dass das Auftrennen der Unterbrecherelemente im Herstellungsverfahren bereits auf dem unzerteilten Wafer vorgenommen werden kann, bzw. nach dem Trennen auf den einzelnen Chips vorgenommen werden kann, ohne dass die Chips bereits auf Systemträgern aufgebracht sind. Im Prinzip kann jedoch das Auftrennen vorzugsweise mittels Lasertechnik auch zu einem späteren Zeitpunkt im Herstellungsverfahren durchgeführt werden, jedoch nicht mehr, wenn die Bausteine bereits aufeinandergestapelt sind, da in dem Falle der Zugriff auf die Unterbrecherelemente mittels eines Verdampfungsstrahls nicht mehr praktikabel ist.

In einem weiteren Durchführungsbeispiel des Verfahrens wird das Verbinden der Eingangskontaktflächen mit den Eingangsanschlußflächen und der Ausgangskontaktflächen mit der Ausgangsanschlußfläche der gestapelten Bausteine mittels eines Bondverfahrens durchgeführt. Dieses Bondverfahren hat den Vorteil, dass auch Bausteine, die mehrere Chips auf einer Stapelzwischenebene aufweisen, auf einem Systemträger untergebracht werden können. Ferner hat das Bondverfahren den Vorteil, dass auch Hybridschaltungen auf einer Stapelzwischenebene verbindbar sind.

In einem bevorzugten Durchführungsbeispiel des Verfahrens werden die Eingangskontaktstifte an den Seitenrändern der gestapelten Bausteine angeordnet. Das Anordnen der Kontaktstifte an den Seitenrändern des elektronischen Bauteils hat gegenüber der Technik mit Durchführungen den Vorteil einer höheren Wirtschaftlichkeit, jedoch auch den Nachteil, dass die Anzahl der unterbringbaren Kontaktstifte begrenzt ist.

Bei einem weiteren Durchführungsbeispiel des Verfahrens werden nun alle Stapelzwischenebenen mit einem identischen Layout gefertigt. Dieses identische Layout weist lediglich die Eingangsanschlußflächen und die gemeinsame Ausgangsanschlußfläche für den Zugriff der gestapelten Stapelzwischenebenen auf und besitzt keine individuellen Adressierschaltungen oder Chipauswahlschaltungen.

In einem weiteren Durchführungsbeispiel des Verfahrens wird die irreversible Zuordnung unmittelbar auf einem Halbleiterwafer mittels Unterbrechen einer vorbestimmten Anzahl der Unterbrecherschaltungen oder der Unterbrecherelemente durchgeführt, nachdem integrierte Schaltungen auf dem Halbleiterwafer fertiggestellt sind, jedoch vor dem Trennen des Halbleiterwafers in einzelne Halbleiterchips. Dieses Verfahren hat insbesondere dann einen wirtschaftlichen Vorteil, wenn in der Chipauswahlschaltung Unterbrecherelemente vorgesehen sind, die durch nachträgliches Verdampfen durchtrennbar sind, so dass mittels Laserscannen oder Elektronenscannen die Chipauswahlschaltungen irreversibel einstellbar sind.

Ein weiteres Durchführungsbeispiel des erfindungsgemäßen Verfahrens sieht vor, dass die irreversible Zuordnung nach einem Aufbringen der Chips auf einem Systemträgerband für Halbleiterchips mittels Anlegen einer Unterbrecherspannung an eine vorbestimmte Anzahl von Unterbrecherschaltungen oder eines Verdampfens einer vorbestimmten Anzahl von Unterbrecherelementen erfolgt. Das irreversible Zuordnen solange die Chips noch auf einem Systemträgerband fixiert sind, hat den Vorteil, dass unmittelbar nach dem Bonden der Halbleiterchips und ihrer Kontaktflächen mit den Kontaktanschlussflächen des Systemträgerbandes die Zuordnung ohne größeren Aufwand durch Anlegen von Unterbrecherspannungen erfolgen kann oder durch Anwenden der Laserstrahltechnik zum Durchtrennen von entsprechend vorbereiteten Unterbrecherelementen auf den Chips. Dazu wird das Systemträgerband durch Strukturieren eines Metallbandes mit Flachleitermustern hergestellt.

Alternativ kann das Systemträgerband aus einem metallkaschierten Folienband durch Strukturieren der Metallschicht zu Leiterbahnen hergestellt werden. Bei dieser Herstellungsweise erfolgt die irreversible Zuordnung nach dem Durchführen der Verbindung vorzugsweise nach Bonden zwischen den Kontaktflächen auf n hintereinander auf dem Systemträgerband angeordneten Chips und Anschlußflächen auf dem Systemträgerband und vor einem Stapeln der Bauelemente zu einem elektronischen Bauteil. Zum Stapeln der Bauteile wird das Systemträgerband in einzelne Systemträger mit Chip aufgetrennt und entsprechend der vorgenommenen Zuordnung werden die vereinzelten Systemträger in der Reihenfolge der Zuordnung der Stapelzwischenebenen aufeinander geschichtet.

Insbesondere beim Stapeln bzw. Stacking von TSOP-Bausteinen, BGA-Packages oder auf Chipebene werden Adress- und Datenleitungen kurzgeschlossen. Über eine Chipauswahlschaltung bzw. einen Chipselect wird jeweils ein Chip der Stackinganordnung aktiv geschaltet. Der Chipselect wird daher für jeden Chip nach außen separat verdrahtet. Deshalb sind in den verschiedenen Stackingebenen auch verschiedene Layouts notwendig, um den Chipselect jeweils anzubinden. Durch die vorliegenden Erfindung wird nun ein einheitliches Layout der Stapelzwischenebenen oder Systemträger möglich. Somit werden durch die Definition des Chipselects auf Chipebene Layout-Kosten gespart, da ein einheitliches Layout für alle Stacking-Zwischenebenen möglich wird, sämtliche Stacking-Zwischenebenen werden auf einfache Weise kurzgeschlossen und der Ausgangsanschluss bzw. PAD-Anschluss für den Chipselect kann auf der Chipebene stattfinden, da die Definition für den Chipselect auf der Chipebene vorgesehen ist. Die Unterbrecherschaltungen können einfache leitungstechnische Sicherungen bzw. Fuses sein, die durch Anlegen einer entsprechend hohen Unterbrecherspannung und damit Ausbilden einer hohen Stromdichte aufschmelzen.

Die Erfindung wird nun anhand von Ausführungsbeispielen unter Bezugnahme auf die beiliegenden Figuren näher erläutert.
- Figur 1: zeigt eine Prinzipskizze in Draufsicht auf einen Baustein aus einem Systemträger und einem Chip mit einer Chipauswahlschaltung auf dem Chip,
- Figur 2: zeigt eine Prinzipskizze in perspektivischer Ansicht eines elektronischen Bauteils aus n gestapelten Bausteinen mit n Chipauswahlschaltungen auf den Chips.

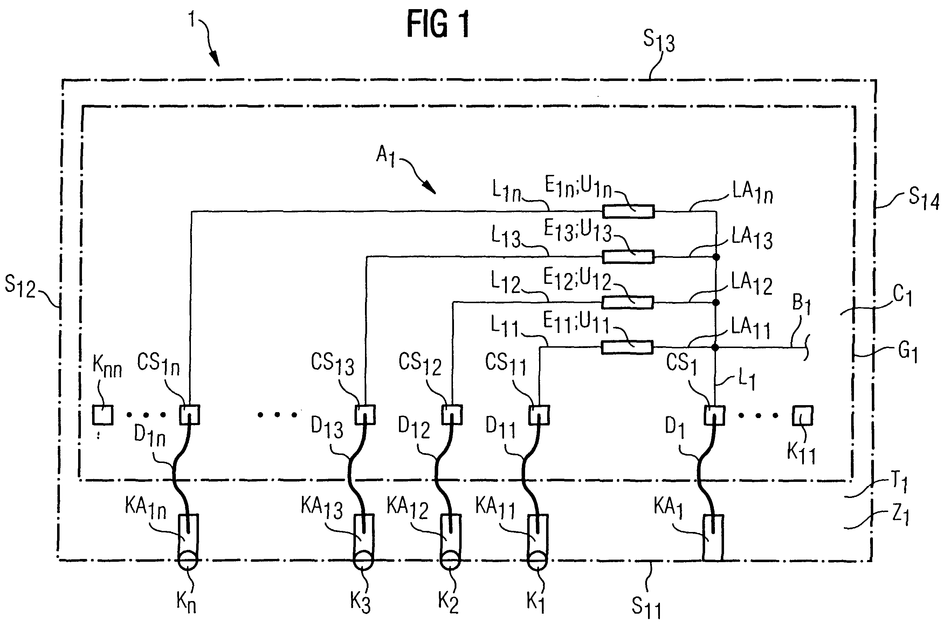

Figur 1 zeigt eine Prinzipskizze in Draufsicht auf einen Baustein 1 aus einem Systemträger T₁ und einem Chip C₁ mit einer Chipauswahlschaltung A₁ auf dem Chip C₁. Die strichpunktierte Linie symbolisiert die Grenze G₁ des Chips C₁. Das Chip C₁ ist auf einem Systemträger T₁ montiert, der die vier Seitenränder S₁₁, S₁₂, S₁₃ und S₁₄ aufweist. Auf dem Chip C₁ ist eine Chipauswahlschaltung A₁ angeordnet, die im wesentlichen aus Unterbrecherschaltungen U₁₁ bis U₁ₙ oder Unterbrecherelementen E₁₁ bis E₁ₙ besteht, wobei die Unterbrecherschaltungen U₁₁ bis U₁ₙ bzw. die Unterbrecherelemente E₁₁ bis E₁ₙ Eingangsleitungen L₁₁ bis L₁ₙ und Ausgangsleitungen LA₁₁ bis LA₁ₙ aufweisen. Während die Ausgangsleitungen LA₁₁ bis LA₁ₙ über eine gemeinsame Ausgangsleitung L₁ mit einer Ausgangskontaktfläche CS₁ auf dem Chip C₁ verbunden sind, werden die Eingangsleitungen L₁₁ bis L₁ₙ separat zu einzelnen Eingangskontaktflächen CS₁₁ bis CS₁ₙ auf dem Chip C₁ geführt. Neben der gemeinsamen Ausgangsleitung L₁ ist auf dem Chip C₁ eine weitere Ausgangsleitung B₁ vorgesehen, auf der beispielsweise ein Adressiersignal weitergeleitet werden kann, während die gemeinsame Ausgangsleitung L₁ der Programmierung bzw. der irreversiblen Zuordnung der Chipauswahlschaltung A₁ dient.

Auf dem Systemträger T₁ sind in diesem Ausführungsbeispiel im Randbereich des Seitenrandes S₁₁ Eingangsanschlußflächen KA₁₁ bis KA₁ₙ angeordnet, die über Bonddrähte D₁₁ bis D₁ₙ mit den Eingangskontaktflächen CS₁₁ bis CS₁ₙ auf dem Chip C₁ verbunden sind. Die Eingangskontaktflächen KA₁₁ bis KA₁ₙ kontaktieren Eingangskontaktstifte K₁ bis Kₙ, die auf dem Seitenrand S₁₁ des Systemträgers T₁ angeordnet sind.

Eine Ausgangsanschlußfläche KA₁ im Randbereich des Seitenrandes S₁₁ des Systemträgers T₁ ist über einen Bonddraht D₁ mit der gemeinsamen Ausgangskontaktfläche CS₁ des Chips C₁ verbunden. Weitere Kontaktflächen _{K11} bis K₁ₘ sind auf dem Chip C₁ angeordnet und korrespondieren mit der integrierten Schaltung auf dem Chip C₁.

Zur irreversiblen Zuordnung des in Figur 1 gezeigten Bausteins 1 zu einer Stapelzwischenebene wird entsprechend der Nummer der Stapelzwischenebene, die von 1 bis n durchnummeriert sind, eine der Unterbrecherschaltungen U₁₁ bis U₁ₙ bzw der Unterbrecherelemente E₁₁ bis E₁ₙ nicht unterbrochen, während die übrigen Unterbrecherschaltungen bzw. Unterbrecherelemente durch Einprägen einer Unterbrecherspannung oder durch eine Verdampfungsbehandlung und mittels Laserstrahl oder Elektronenstrahl unterbrochen werden. Damit wird eindeutig einer der Eingangskontaktstifte K₁ bis Kₙ der Adressenleitung B₁ zugeordnet. Bei der Ausführungsform nach Figur 1 ist die Chipauswahlschaltung A₁ somit auf dem Chip C₁ selbst angeordnet und nicht auf der Stapelzwischenebene Z₁ bzw. auf dem Träger T₁, so dass sämtliche Stapelzwischenebenen Z₁ bis Zₙ der Bausteine 1 - n des elektronischen Bauteils vollkommen identisch aufgebaut werden können. Während die Eingangsanschlußflächen KA₁₁ bis KA₁ₙ auf dem Systemträger T₁ mit Eingangskontaktstiften K₁ bis Kₙ verbunden werden, wird die gemeinsame Ausgangsanschlußfläche KA₁ der Bausteine nicht miteinander durch einen Kontaktstift verbunden, sondern diese Ausgangsanschlußfläche dient lediglich der Programmierung der Chipauswahlschaltungen A₁ bis Aₙ auf den Chips C₁ bis Cₙ.

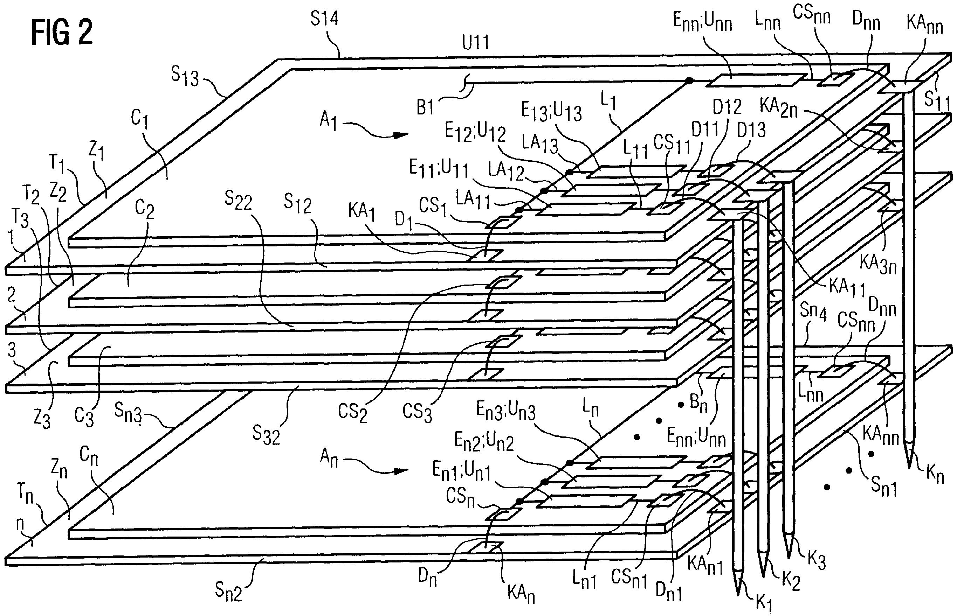

Figur 2 zeigt eine Prinzipskizze in perspektivischer Ansicht eines elektronischen Bauteils aus n gestapelten Bausteinen 1 bis n mit n Chipauswahlschaltungen A₁ bis Aₙ auf den Chips C₁ bis Cₙ. Die Bausteine 1 - n sind übereinander gestapelte angeordnet. Der oberste Baustein 1 der Figur 2 entspricht dem Baustein der Figur 1. Gleiche Bezugszeichen kennzeichnen gleiche Konstruktionselemente und werden deshalb nicht erneut erläutert. Die Bausteine 1 - n weisen jeweils einen Systemträger T₁ bis Tₙ mit einer Stapelzwischenebene Z₁ bis Zₙ auf.

Auf jedem Systemträger T₁ bis Tₙ ist ein Chip C₁ bis Cₙ angeordnet. Jedes Chip C₁ bis Cₙ weist neben einer integrierten Schaltung eine Chipauswahlschaltung A₁ bis Aₙ auf. Die Chipauswahlschaltungen A₁ bis Aₙ bestehen im wesentlichen aus Unterbrecherschaltungen U₁₁ bis Uₙₙ oder Unterbrecherelementen E₁₁ bis Eₙₙ. Separate Eingangsleitungen L₁₁ bis L₁ₙ verbinden die Unterbrecherschaltungen bzw. die Unterbrecherelemente mit Eingangskontaktflächen CS₁₁ bis CSₙₙ auf den Chips C₁ bis Cₙ. Die Chips C₁ bis Cₙ sind in diesem Ausführungsbeispiel Halbleiterchips, die mindestens eine integrierte Schaltung aufweisen. Die Adressierung dieser integrierten Schaltung erfolgt über die gemeinsame Ausgangsleitung B₁ bis Bₙ der jeweiligen Chipauswahlschaltung A₁ bis Aₙ. Nach der oben erörterten Zuordnung der Chipauswahlschaltungen A₁ bis Aₙ der Bausteine 1 - n besteht eine unmittelbare Verbindung der einzelnen Eingangskontaktstifte K₁ bis Kₙ zu den Ausgangsleitungen B₁ bis Bₙ, so dass über die Eingangskontaktstifte K₁ bis Kₙ die integrierten Schaltungen auf den Stapelzwischenebenen adressiert werden können.

Das in Figur 2 abgebildete elektronische Bauelement aus gestapelten Bausteinen 1 - n, die beispielsweise TSOP-Bausteine sein können, wurde in dieser Ausführungsform mit dem folgenden Verfahren hergestellt. Zunächst wurde während der Einbringung der integrierten Schaltung auf die Chips C₁ bis Cₙ gleichzeitig auch die Chipauswahlschaltung mit einer Anzahl Unterbrecherschaltungen U₁₁ bis U₁ₙ aufgebracht, wobei die Unterbrecherschaltungen getrennter Eingangskontaktflächen CS₁₁ bis CS₁ₙ und eine gemeinsame Ausgangskontaktfläche CS₁ aufweisen.

Derart ausgestaltete Chips C₁ bis Cₙ werden auf einem Systemträgerband mit hintereinander angeordneten Systemträgern T₁ bis Tₙ aufgebracht, wobei das Systemträgerband ein strukturiertes Metallband mit Flachleitermustern sein kann oder aus einem Folienband mit Metallkaschierung bestehen kann. Im Falle des Folienbandes wird die Metallschicht der Metallkaschierung zu Leiterbahnen strukturiert und zusätzlich werden Ausgangsanschlußflächen und Eingangsanschlußflächen auf dem Systemträgerband vorgesehen. Noch während die Chips C₁ bis Cₙ auf dem Systemträgerband hintereinander angeordnet sind, können sie mit Bonddrähten versehen werden, wobei die Bonddrähte für die Chipauswahlschaltungen A₁ bis Aₙ sowohl die separaten Eingangskontaktflächen als auch die gemeinsame Ausgangskontaktfläche jeder Chipauswahlschaltung A₁ bis Aₙ mit den entsprechenden auf dem Systemträgerband vorgesehenen Eingangsanschlußflächen bzw. Ausgangsanschlußflächen verbinden.

Zur irreversiblen Zuordnung der Bausteine 1 bis n zu der Lage im Stapel und zur eindeutigen Adressierung der einzelnen integrierten Schaltung in dem Stapel kann noch auf dem Systemträgerband diese Zuordnung vorgenommen werden, indem ensprechende Unterbrecherspannungen an die Eingangsanschlußflächen KA₁₁ bis KAₙₙ bzw. die Ausgangsanschlußflächen KA₁ bis KAₙ angelegt werden. Dabei wird jeweils eine der Unterbrecherschaltungen U₁₁ bis Uₙₙ, die für den Baustein 1 bis n charakteristisch ist nicht mit einer Unterbrecherspannung beaufschlagt.

Nachdem in dieser Weise mit Hilfe der Chipauswahlschaltungen A₁ bis Aₙ die Bausteine irreversibel zugeordnet sind, wird das Systemträgerband in einzelne Systemträger getrennt und diese mit den darauf befindlichen Chips C₁ bis Cₙ in der vorgesehenen Reihenfolge übereinander gestapelt und, wie es Figur 2 zeigt, an einem der Seitenränder S₁₁ bis Sₗₙ mit Eingangskontaktstiften K₁ bis Kₙ versehen, welche die übereinanderliegenden Eingangsanschlußflächen miteinander verbinden. Aufgrund der vorher durchgeführten irreversiblen Zuordnung mit Hilfe der Chipauswahlschaltungen A₁ bis Aₙ sind damit die Eingangskontaktstifte K₁ bis Kₙ jeweils eindeutig mit einer der Adressenleitungen B₁ bis Bₙ auf den Chips C₁ bis Cₙ verbunden. Die Leitungsstruktur der Systemträger T₁ bis Tₙ ist für alle Stapelzwischenebenen Z₁ bis Zₙ identisch, so dass ein einziges Layout für sämtliche Stapelzwischenebenen erforderlich ist.

### Bezugszeichenliste

- 1 - n: Baustein
- C₁ bis Cₙ: Chip
- Z₁ bis Zₙ: Stapelzwischenebene
- T₁ bis Tₙ: Systemträger
- CS₁ bis CSₙ: Ausgangskontaktfläche
- CS₁₁ bis CSₙₙ: Eingangskontaktfläche
- A₁ bis Aₙ: Chipauswahlschaltung
- U₁₁ bis Uₙₙ: Unterbrecherschaltungen
- L₁₁ bis Lₙₙ: Eingangsleitungen
- KA₁ bis Kaₙ: Ausgangsanschlußfläche
- KA₁₁ bis Kaₙₙ: Eingangsanschlußfläche
- L₁ bis Lₙ: gemeinsame Ausgangsleitungen
- K₁ bis Kₙ: Eingangskontaktstift
- E₁₁ bis Eₙₙ: Unterbrecherelement
- D₁ bis Dₙ: Ausgangsbonddraht
- D₁₁ bis Dₙₙ: Eingangsbonddraht
- S₁₁ bis Sₙ₄: Seitenränder der Systemträger
- B₁ bis Bₙ: Adressenleitung
- LA₁₁ bis LAₙₙ: Ausgangsleitungen der Unterbrecherschaltungen bzw. der Unterbrecherelemente
- K₁₁ bis K₁ₙ: Kontaktflächen auf dem Chip
- G₁ bis Gₙ: Grenzlinie des Chips

## Patentansprüche

1. Elektronisches Bauteil mit gestapelten Bausteinen (1 - n), wobei jeder Baustein (1 - n) einen Chip (C₁ bis Cₙ) aufweist, der auf einer Stapelzwischenebene (Z₁ bis Zₙ) montiert ist und die Stapelzwischenebenen (Z₁ bis Zₙ) eines Stapels ein identisches Layout aufweisen, während auf den Chips (C₁ bis Cₙ) irreversibel über Kontaktflächen (CS₁ bis CSₙ und CS₁₁ bis CSₙₙ) einstellbare Chipauswahlschaltungen (A₁ bis Aₙ) angeordnet sind, die eine irreversible Zuordnung der Kontaktflächen (CS₁ bis CSₙ und CS₁₁ bis CSₙₙ) zu den Stapelzwischenebenen (Z₁ bis Zₙ) ermöglichen.

2. Elektronisches Bauteil nach Anspruch 1,
**dadurch gekennzeichnet, daß**
die Chipauswahlschaltung (A₁ bis Aₙ) eine Anzahl Unterbrecherschaltungen (U₁₁ bis Uₙₙ), deren Anzahl auf jedem Chip (C₁ bis Cₙ) mindestens der Anzahl der Stapelzwischenebenen (Z₁ bis Zₙ) entspricht.

3. Elektronisches Bauteil nach Anspruch 2,
**dadurch gekennzeichnet, daß**
jede Unterbrecherschaltung (U₁₁ bis Uₙₙ) über eine Eingangsleitung (L₁₁ bis Lₙₙ) mit einer Eingangskontaktfläche (CS₁₁ bis CSₙₙ) und über eine Ausgangsleistung (L₁ bis Lₙ) mit einer Ausgangskontaktfläche (CS₁ bis CSₙ) verbunden ist.

4. Elektronisches Bauteil nach Anspruch 2 oder Anspruch 3,
**dadurch gekennzeichnet, dass**
die Unterbrecherschaltung (U₁₁ bis Uₙₙ) eine gemeinsame Ausgangskontaktfläche (CS₁ bis CSₙ) und getrennte Eingangskontaktflächen (CS₁₁ bis CSₙₙ) aufweisen.

5. Elektronisches Bauteil nach Anspruch 4,
**dadurch gekennzeichnet, daß**
die Eingangskontaktflächen (CS₁₁ bis CSₙₙ) der Unterbrecherschaltung (U₁₁ bis Uₙₙ) über gebondete Drähte (D₁₁ bis Dₙₙ) mit Eingangsanschlußflächen (KA₁₁ bis KAₙₙ) auf den Stapelzwischenebenen (Z₁ bis Zₙ) verbunden sind.

6. Elektronisches Bauteil nach Anspruch 5,
**dadurch gekennzeichnet, daß**
die Eingangsanschlußflächen (KA₁₁ bis KAₙₙ) auf den Stapelzwischenebenen (Z₁ bis Zₙ) mit Eingangskontaktstiften (K₁ bis Kₙ) verbunden sind, welche die gestapelten Bausteine (1 - n) verbinden.

7. Elektronisches Bauteil nach einem der Ansprüche 4 bis 6,
**dadurch gekennzeichnet, daß**
die gemeinsame Ausgangskontaktfläche (CS₁ bis CSₙ) der Chipauswahlschaltung (A₁ bis Aₙ) jeweils einen gebondeten Draht (D₁₁ bis Dₙₙ) mit einer gemeinsamen Ausgangsanschlußfläche (KA₁ bis KAₙ) auf der Stapelzwischenebene (Z₁ bis Zₙ) verbunden ist.

8. Elektronisches Bauteil nach einem der Ansprüche,
**dadurch gekennzeichnet, daß**
die Eingangsanschlußflächen (KA₁₁ bis KAₙₙ) der Stapelzwischenebenen (Z₁ bis Zₙ) über Durchkontakte zu Eingangskontaktstiften (K₁ bis Kₙ) auf der Grundfläche des elektronischen Bauteils mit gestapelten Bausteinen (1-n) geführt sind.

9. Elektronisches Bauteil nach einem der Ansprüche 1 bis 8,
**dadurch gekennzeichnet, daß**
die Eingangsanschlußflächen (KA₁₁ bis KAₙₙ) der Stapelzwischenebenen (Z₁ bis Zₙ) im Randbereich jeder Stapelzwischenebene (Z₁ bis Zₙ) angeordnet sind und über Eingangskontaktstifte (K₁ bis Kₙ) auf den Seitenflächen (S₁₁ bis Sₙ₄) des elektronischen Bauteils verbunden sind.

10. Verfahren zur Herstellung eines elektronischen Bauteils mit gestapelten Bausteinen (1 - n) unter irreversibler Festlegung und Zuordnung von Eingangskontaktstiften (K₁ bis Kₙ) als Adressenkontakte, das folgende Verfahrensschritte aufweist:
- Aufbringen einer Chipauswahlschaltung (A₁) mit einer Anzahl Unterbrecherschaltungen (U₁₁ bis U₁ₙ) auf einen Chip (C₁), die getrennte Eingangskontaktflächen (CS₁₁ bis CS₁ₙ) und eine gemeinsame Ausgangskontaktfläche (CS₁) aufweist,
- Aufbringen des Chips (C₁) auf einem Systemträger (T₁) mit einer Stapelzwischenebene (Z₁), die eine Anzahl getrennter Eingangsanschlußflächen (KA₁₁ bis KA₁ₙ) und eine Ausgangsanschlußfläche (KA₁) aufweist,
- Verbinden der Eingangskontaktflächen (CS₁₁ bis CSₙₙ) mit den Eingangsanschlußflächen (KA₁₁ bis KAₙₙ) und der Ausgangskontaktflächen (CS₁ bis CSₙ) mit der Ausgangsanschlußfläche (KA₁),
- Anlegen einer Unterbrecherspannung zwischen einer gemeinsamen Ausgangsanschlußfläche (KA₁) für alle Unterbrecherschaltungen (U₁₂ bis U₁ₙ) eines Chips (C₁) auf einer Stapelzwischenebene (Z₁ bis Zₙ) und nacheinander aller Eingangskontaktflächen (CS₁₁ bis CS₁ₙ) der Unterbrecherschaltungen (U₁₂ is U₁ₙ) dieser Stapelzwischenebene (Z₁ bis Zₙ) dieses Chips (C₁) mit Ausnahme der Eingangskontaktfläche (CS₁₁), die für diese Stapelzwischenebene (Z₁) kennzeichnend ist und einer Adressierung dienen soll,
- Stapeln einer Anzahl von Bausteinen (1 - n) aus Chips (C₁ bis Cₙ) und Systemträgern (T₁ bis Tₙ) mit Stapelzwischenebenen (Z₁ bis Zₙ),
- Anbringen von Eingangskontaktstiften (K₁ bis Kₙ) und einem Ausgangskontaktstift (K₀) zur Verbindung der Eingangsanschlußflächen (KA₁₁ bis KAₙₙ) bzw. der Ausgangsanschlußflächen (KA₁ bis KAₙ) der gestapelten Bausteine (1 - n).

11. Verfahren zur Herstellung eines elektronischen Bauteils mit gestapelten Bausteinen (1 - n) unter irreversibler Festlegung und Zuordnung von Eingangskontaktstiften (K₁ bis Kₙ) als Adressenkontakte, das folgende Verfahrensschritte aufweist:
- Aufbringen einer Chipauswahlschaltung (A₁) mit einer Anzahl Unterbrecherelemente (E₁₁ bis E₁ₙ) auf einem Chip (C₁), die getrennte Eingangskontaktflächen (CS₁₁ bis CS₁ₙ) und eine gemeinsame Ausgangskontaktfläche (CS₁) aufweisen,
- Auftrennen der Unterbrecherelemente (E₁₂ bis E₁ₙ) vorzugsweise mittels Laserverdampfen, soweit sie nicht der Adressierung des Chips (C₁ bis Cₙ) dienen,
- Aufbringen des Chips (C₁) auf einem Systemträger (T₁) mit einer Stapelzwischenebene (Z₁), die eine Anzahl getrennter Eingangsanschlußflächen (KA₁₁ bis KA₁ₙ) und eine Ausgangsanschlußfläche (KA₁) aufweist,
- Verbinden der Eingangskontaktflächen (CS₁₁ bis CSₙₙ) mit den Eingangsanschlußflächen (KA₁₁ bis KA₁ₙ) und der Ausgangskontaktfläche (CS₁) mit der Ausgangsanschlußfläche (KA₁),
- Stapeln einer Anzahl von Bausteinen (1 - n) aus Chips (C₁ bis Cₙ) und Systemträgern (T₁ bis Tₙ), mit Stapelzwischenebenen (Z₁ bis Zₙ),
- Anbringen von Eingangskontaktstiften (K₁ bis Kₙ) zur Verbindung der Eingangsanschlußflächen (KA₁₁ bis KA₁ₙ) der gestapelten Bausteine (1 - n).

12. Verfahren nach Anspruch 10 oder Anspruch 11,
**dadurch gekennzeichnet, daß**
das Verbinden der Eingangskontaktflächen (CS₁₁ bis CS₁ₙ) mit den Eingangsanschlußflächen (KA₁₁ bis KA₁ₙ) und der Ausgangskontaktfläche (CS₁) mit der Ausgangsanschlußfläche (KA₁) mittels eines Bondverfahrens durchgeführt wird.

13. Verfahren nach einem der Ansprüche 10 bis 12,
**dadurch gekennzeichnet, daß**
die Eingangskontaktstifte (K₁ bis Kₙ) an den Seitenrändern (S₁₁ bis Sₙ₄) der gestapelten Bausteine (1 - n) angeordnet werden.

14. Verfahren nach einem der Ansprüche 10 bis 13,
**dadurch gekennzeichnet, daß**
ein identisches Layout für alle Stapelzwischenebenen (Z₁ bis Zₙ) gefertigt wird.

15. Verfahren nach einem der Ansprüche 10 bis 14,
**dadurch gekennzeichnet, daß**
die irreversible Zuordnung unmittelbar auf einem Halbleiterwafer mittels Unterbrechen einer vorbestimmten Anzahl der Unterbrecherschaltungen (U₁₁ bis Uₙₙ) oder der Unterbrecherelemente (E₁₁ bis Eₙₙ) durchgeführt wird, nachdem integrierte Schaltungen auf dem Halbleiterwafer fertiggestellt sind.

16. Verfahren nach einem der Ansprüche 10 bis 15,
**dadurch gekennzeichnet, daß**
die irreversible Zuordnung nach einem Aufbringen des Chips nach einem Systemträgerband für Halbleiterchips mittels Anlegen einer Unterbrecherspannung an eine vorbestimmte Anzahl von Unterbrecherschaltungen (U₁₁ bis Uₙₙ) oder eines Verdampfens einer vorbestimmten Anzahl von Unterbrecherelementen (E₁₁ bis Eₙₙ) erfolgt.

17. Verfahren nach Anspruch 16,
**dadurch gekennzeichnet, daß**
das Systemträgerband durch Strukturieren eines Metallbandes mit Flachleitermustern hergestellt wird.

18. Verfahren nach Anspruch 16 oder Anspruch 17,
**dadurch gekennzeichnet, daß**
das Systemträgerband aus einem metallkaschierten Folienband durch Strukturieren der Metallschicht des Folienbandes zu Leiterbahnen hergestellt wird.

19. Verfahren nach einem der Ansprüche 16 bis 18,
**dadurch gekennzeichnet, daß**
die irreversible Zuordnung nach Durchführung der Verbindung zwischen Kontaktflächen (CS₁ bis CSₙ und CS₁₁ bis CSₙₙ) von hintereinander auf dem Systemträgerband angeordneten Chips (C₁ bis Cₙ) und Ausgangsanschlußflächen (KA₁ bis KAₙ) und Eingangsanschlußflächen (KA₁₁ bis KAₙₙ) auf dem Systemträgerband und vor einem Stapeln der Bauteile (1 - n) zu einem elektronischen Bauteil hergestellt wird.
